# FASCICULE DE BREVET EUROPEEN

(11) **EP 1 133 684 B1**
(45) Date de publication et mention de la délivrance du brevet: **04.11.2009**
(21) Numéro de dépôt: 99956159.0
(22) Date de dépôt: 26.11.1999
(51) Int. Cl.: G01L 9/00

(54) **STRUCTURE MICRO-USINEE A MEMBRANE DEFORMABLE ET SON PROCEDE DE REALISATION**
MIKROMECHANISCHE STRUKTUR MIT EINER DEFORMIERBAREN MEMBRAN UND VERFAHREN ZU IHRER HERSTELLUNG
MICROMACHINED STRUCTURE WITH DEFORMABLE MEMBRANE AND METHOD FOR MAKING SAME

(30) Priorité: 27.11.1998 FR 9814969
(43) Date de publication de la demande: 19.09.2001
(73) Titulaire: COMMISSARIAT A L'ENERGIE ATOMIQUE, 75015 Paris (FR)
(72) Inventeur: JAUSSAUD, Claude, F-38240 Meylan (FR); CLERC, Jean-Frédéric, F-38120 Le Fontanil (FR)
(74) Mandataire: Audier, Philippe André
(86) Numéro de dépôt international: PCT/FR1999/002936
(87) Numéro de publication internationale: WO 2000/033045

(56) Documents cités:
- DE-A- 19 601 791
- FR-A- 2 681 472
- US-A- 3 922 705
- US-A- 4 706 100
- PATENT ABSTRACTS OF JAPAN vol. 096, no. 010, 31 octobre 1996 (1996-10-31) & JP 08 148696 A (MITSUBA ELECTRIC MFG CO LTD), 7 juin 1996 (1996-06-07)
- PATENT ABSTRACTS OF JAPAN vol. 017, no. 264 (E-1370), 24 mai 1993 (1993-05-24) & JP 05 006883 A (NIPPON STEEL CORP), 14 janvier 1993 (1993-01-14)

## Description

### Domaine technique

La présente invention concerne une structure micro-usinée à membrane déformable. Elle concerne aussi un procédé de réalisation d'une telle structure micro-usinée. Elle concerne en particulier une structure micro-usinée pour un capteur fonctionnant à haute température et notamment pour un capteur de pression.

### Etat de la technique antérieure

Les techniques de la micro-électronique permettent la réalisation de capteurs de pression miniatures par des procédés de fabrication collective. Elles procurent donc des capteurs de dimensions réduites et de faible coût. Elles permettent la réalisation sur un même support d'un capteur et de son électronique associée.

On connaît des capteurs de pression micro-usinés constitués d'une membrane de silicium de quelques dizaines de µm d'épaisseur. La différence de pression entre les deux faces de la membrane peut être détectée par la mesure des contraintes à l'encastrement avec des jauges piézorésistives obtenues par diffusion ou implantation ionique. Ces jauges piézoélectriques présentent une sensibilité élevée et une grande stabilité mécanique due à la structure monocristalline du silicium utilisé. On réalise l'isolation électrique entre chaque jauge et avec le substrat sur lequel elles sont élaborées par des jonctions inverses. Ceci a pour inconvénient de limiter la gamme de température de fonctionnement de ces capteurs à 125°C maximum à cause du courant de fuite élevé de la jonction inverse et d'introduire un niveau de bruit élevé (bruit thermique et bruit de jonction piézoélectrique) ce qui réduit la gamme dynamique.

Pour obtenir une structure micro-usinée pour capteur de pression fonctionnant à haute température, plusieurs solutions ont été étudiées.

Une première solution consiste en une structure comportant un film de carbure de silicium (SiC) servant de membrane déformable et comprenant les éléments de détection, ce film de SiC étant déposé sur un support en silicium usiné pour libérer la membrane. Une telle structure présente l'inconvénient d'être limitée en température par les fuites électriques de la jonction présentée par l'interface Si-SiC dès 200°C.

Une deuxième solution, directement dérivée de la première, consiste à intercaler une couche isolante (de l'oxyde de silicium) entre le film de SiC et le support en silicium. Dans ce cas, la structure micro-usinée comporte une membrane constituée d'une superposition de trois couches : le film de SiC superficiel, la couche intermédiaire d'oxyde et une couche de silicium subsistant après l'usinage du support en silicium. La présence de la couche isolante procure une structure pour laquelle les fuites électriques sont limitées. Cependant, au-delà de 500°C la partie en silicium de la membrane perd ses propriétés élastiques et se déforme.

Une troisième solution consiste à réaliser la structure micro-usinée à partir d'un substrat de SiC massif. Cette solution convient à la fois sur le plan électrique et sur le plan mécanique. Cependant, la fabrication de la membrane s'avère difficile, le carbure de silicium étant très difficile à graver. De plus, cette solution est chère du fait du prix de revient élevé des substrats en carbure de silicium.

Le brevet américain n° 5 165 283 divulgue des transducteurs de pression fonctionnant à température élevée et plus particulièrement des transducteurs employant du carbure de silicium. Le carbure de silicium est formé par croissance sur du silicium. Le matériau obtenu présente alors une grande densité de défauts qui vont favoriser les fuites de jonction et limiter la tenue en température.

Le document US-A-3 922 705 décrit un diaphragme sensible à la pression et isolé diélectriquement, correspondant au préambule de la revendication 1.

Le document DE-A-196 01 791 divulgue un détecteur à membrane et son procédé de fabrication. Le détecteur est une structure micro-usinée comportant une membrane déformable solidaire d'un support permettant sa déformation. Le support est en silicium. La membrane comprend une couche en SiC et une couche en SiO₂. Les éléments de détection sont situés sur la couche électriquement isolante et sont fabriqués à partir d'une couche métallique.

Le document US-A-4 706 100 divulgue un capteur de pression piézorésistif comprenant un substrat de silicium monocristallin, une couche épitaxiée de β-SIC monocristallin, des résistances piézoélectriques formées par diffusion ou implantation dans la couche épitaxiée, des contacts électriques pour connecter les résistances piézoélectriques, une cavité formée sur la face arrière du substrat pour former une membrane.

### Exposé de l'invention

L'invention procure une solution aux inconvénients présentés par les structures de l'art antérieur. Elle permet de réaliser une structure micro-usinée comportant une membrane qui reste élastique même à haute température, et dont le support est constitué de matériau facile à graver. Le matériau du support n'a donc pas besoin de posséder des propriétés élastiques particulières à haute température.

En outre, selon l'invention, les éléments de détection ne sont pas réalisés directement dans la couche de membrane, ce qui permet d'avoir une couche de membrane choisie pour ses fonctions élastiques saris contrainte de propriétés électriques. En outre, les éléments de détection sont isolés électriquement de la couche de membrane, ce qui permet d'éviter les fuites électriques de jonction.

L'invention a donc pour objet une structure micro-usinée comportant une membrane déformable solidaire d'un support permettant sa déformation, la membrane comprenant au moins une couche de membrane en matériau semiconducteur, ladite couche de membrane supportant des éléments de détection de la déformation de la membrane réalisés en matériau semiconducteur, la membrane présentant une interface électriquement isolante avec les éléments de détection constituée par une couche électriquement isolante et comportant en outre une couche superficielle en carbure de silicium monocristallin dans laquelle sont réalisés lesdits éléments de détection, ladite couche superficielle étant une couche reportée sur la couche électriquement isolante, la couche de membrane étant, en carbure de silicium, les éléments de détection étant, en carbure de silicium monocristallin et le support étant en silicium. Dans ce cas, la couche électriquement isolante peut être. constituée par une couche d'oxyde de silicium.

Selon un premier mode de réalisation, le support est gravé localement, totalement ou partiellement pour libérer la membrane. Selon un deuxième mode de réalisation, le support est obtenu par dépôt sur une matrice, par une gravure locale ou par planarisation de ce dépôt et élimination de la matrice. Le support peut être réalisé en un matériau massif ou non. Il peut notamment être constitué par un substrat de type SOI ou un substrat de silicium.

L'invention a aussi pour objet un procédé de fabrication par micro-usinage d'au moins une structure à membrane déformable solidaire d'un support caractérisé en ce qu'il comporte les étapes suivantes :
la formation, sur une face d'un substrat initial en silicium, d'une couche de membrane en carbure de silicium,
- le report, sur la couche de membrane formée sur ledit substrat, d'une couche superficielle en carbure de silicium monocristallin, avec interposition d'une couche électriquement isolante,
- la réalisation sur la face libre de la couche superficielle d'éléments de détection tels que des jauges piézorésistives destinés à servir de moyens de détection de la déformation de la membrane,
- la réalisation de contacts électriques sur ladite face libre destinés à connecter les éléments de détection à des moyens de liaison électrique,
- la libération de la membrane de ladite structure.

La libération de la membrane d'une structure peut se faire par élimination de matière à partir de l'autre face du substrat. Elle peut aussi se faire par élimination d'une matrice de forme complémentaire à la structure micro-usinée..

Dans le cas d'un procédé de fabrication collective, ce procédé comporte alors une étape finale de découpe pour obtenir des structures séparées.

La formation de la couche de membrane peut se faire par dépôt.

Selon une première variante, le report de ladite couche superficielle en carbure de silicium monocristallin est obtenu à partir d'une plaquette du même matériau dans laquelle cette couche superficielle a été définie par une couche de microcavités générées par implantation ionique, ladite plaquette étant collée sur la couche de membrane formée sur le substrat initial, puis clivée au niveau de la couche de microcavités pour ne conserver que la couche superficielle sur la couche de membrane. Selon une deuxième variante, le report de ladite couche superficielle en carbure de silicium monocristallin est obtenu à partir d'une plaquette comprenant une couche du même matériau solidaire d'un substrat support, la couche superficielle étant définie dans ladite couche du même matériau par une couche de microcavités générées par implantation ionique, ladite plaquette étant collée sur la couche de membrane formée sur le substrat initial, puis clivée au niveau de la couche de microcavités pour ne conserver que la couche superficielle sur la couche de membrane. Le clivage de la plaquette peut être obtenu par la coalescence des microcavités résultant d'un traitement thermique. L'épaisseur de la couche superficielle reportée peut être complétée et contrôlée par épitaxie du même matériau constituant cette couche superficielle.

Selon une troisième variante, le report de ladite couche superficielle en carbure de silicium monocristallin est obtenu à partir d'une plaquette comprenant ladite couche superficielle solidaire d'un substrat support, ladite plaquette étant collée sur la couche de membrane formée sur le substrat initial, le substrat support de la plaquette étant ensuite éliminé pour ne conserver que la couche superficielle sur la couche de membrane. Cette élimination du substrat support peut être réalisée par une méthode choisie parmi la gravure et la dissolution chimique.

Avantageusement, pour ces trois variantes du procédé, le collage de la plaquette sur la couche de membrane est obtenu par adhésion moléculaire.

La couche électriquement isolante interposée entre la couche superficielle et la couche de membrane peut être composée d'une première couche électriquement isolante formée sur la couche superficielle et d'une deuxième couche électriquement isolante formée sur la couche de membrane, lesdites première et deuxième couches électriquement isolantes étant choisies pour contribuer au collage par adhésion moléculaire.

Si les éléments de détection sont des jauges piézorésistives, celles-ci peuvent être réalisées par une méthode choisie parmi l'implantation ionique et la diffusion ionique. Les contacts électriques peuvent être réalisés par dépôt d'une couche métallique sur la face libre de la couche superficielle et par gravure de cette couche métallique.

De préférence, ladite élimination de matière est obtenue par une méthode choisie parmi l'usinage mécanique et la gravure chimique.

### Brève description des dessins.

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1F illustrent une première variante du procédé de fabrication de structures micro-usinées à membrane déformable selon la présente invention,
- les figures 2A à 2C illustrent une deuxième variante du procédé de fabrication de structures micro-usinées à membrane déformable selon la présente invention,
- les figures 3A à 3C illustrent une troisième variante du procédé de fabrication de structures micro-usinées à membrane déformable selon la présente invention,
- les figures 4A à 4F illustrent une quatrième variante du procédé de fabrication de structures micro-usinées à membrane déformable selon la présente invention.

### Description détaillée de modes de réalisation de l'invention

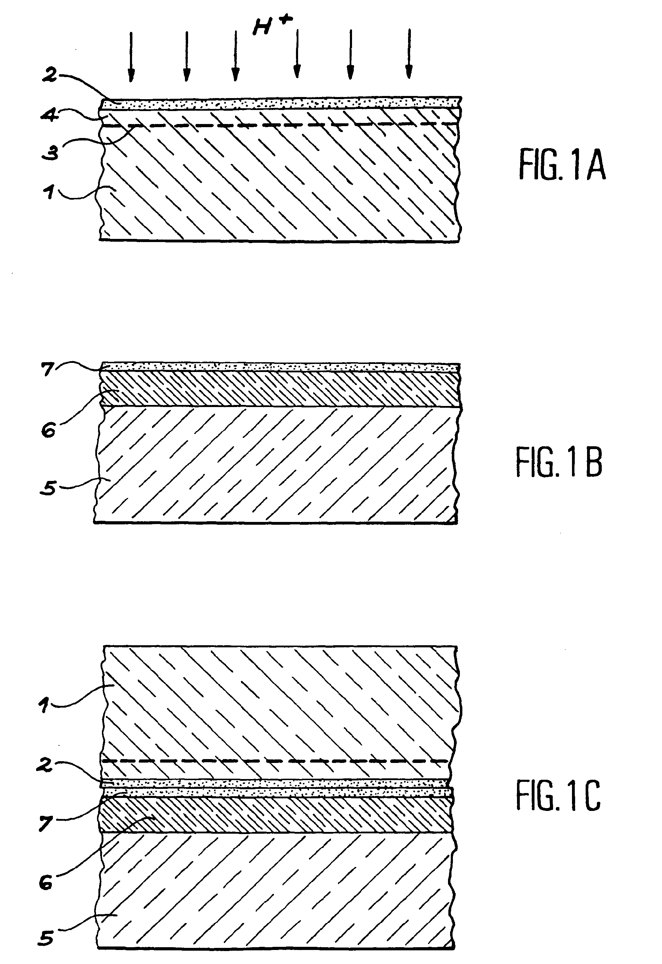

Les figures 1A à 1F sont des vues en coupe qui illustrent une première variante de réalisation de structures micro-usinées selon l'invention. Par souci de simplification on a représenté la réalisation d'une seule structure.

La figure 1A montre une plaquette 1 de matériau semiconducteur, par exemple du carbure de silicium monocristallin. Sur la plaquette 1, on a déposé une couche 2 d'oxyde de silicium dont l'épaisseur est de l'ordre de 500 nm.

La figure 1B montre un substrat 5 en matériau facilement usinable par une technique de la micro-électronique, par exemple un substrat de silicium. Sur le substrat 5, on dépose une couche 6, par exemple une couche de carbure de silicium monocristallin de 5 µm d'épaisseur. La couche 6 est destinée à former la couche de membrane de la structure. Sur la couche 6, on forme une couche 7 d'oxyde de silicium par oxydation thermique ou par dépôt. L'épaisseur de la couche 6 est de l'ordre de 500 nm.

Il s'agit maintenant de reporter sur le substrat 5 une couche superficielle du matériau de la plaquette 1 en faisant en sorte que les couches d'oxyde 2 et 7 soient en contact intime. Ce report est, selon cette première variante du procédé, réalisé par la méthode de transfert divulgué par la demande FR-A-2 681 472. Selon cette méthode de transfert, la plaquette 1 est bombardée au travers de la couche d'oxyde 2 par des ions (d'hydrogène par exemple) de façon à créer à l'intérieur de la plaquette une couche de microcavités 3 parallèle à la face bombardée (voir la figure 1A). La couche de microcavités 3 est située à une profondeur correspondant à l'épaisseur de la couche 4 que l'on veut reporter.

La plaquette 1 est ensuite collée sur le substrat 5 par mise en contact intime de leurs couches d'oxyde 2 et 7. Le collage peut avantageusement être réalisé par la technique d'adhésion moléculaire. On obtient l'assemblage représenté à la figure 1C.

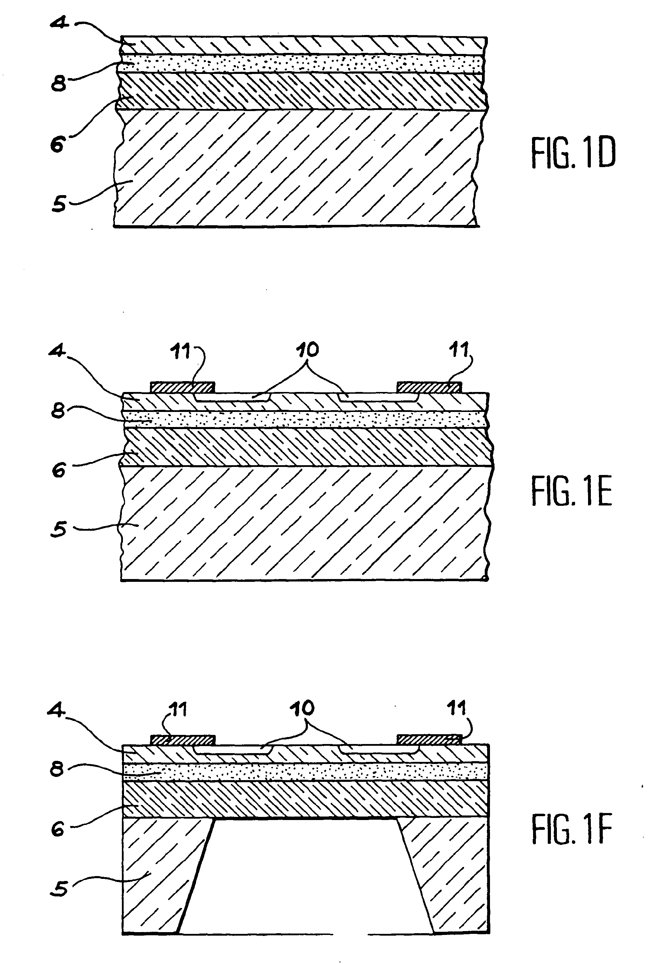

Par un traitement thermique approprié éventuellement assisté par l'application de forces mécaniques, on provoque la coalescence des microcavités et le clivage de la plaquette le long de la couche de microcavités. On obtient alors, comme le montre la figure 1D, une couche superficielle 4 adhérant au substrat 5 et séparée du reste de la plaquette qui est réutilisable. Sur la figure 1D, les couches d'oxyde réunies par collage sont désignées sous la référence unique 8.

La présence d'une couche isolante, par exemple en oxyde de silicium SiO₂ est avantageuse par rapport à une isolation par jonction. L'isolation par oxyde permet une tenue à plus haute température qu'une jonction. De plus, le bruit électronique est plus faible dans le cas d'une isolation par diélectrique que dans le cas d'une isolation par jonction.

La face libre de la couche superficielle 4 peut recevoir un dépôt par épitaxie du même matériau que celui constituant cette couche. Ceci permet de compléter et de contrôler finement l'épaisseur de cette couche.

La couche 4 en SiC monocristallin est particulièrement intéressante parce que ce matériau a un coefficient piézoélectrique plus élevé que le SiC polycristallin. Il est plus reproductible (pas de problèmes liés à la taille des grains ni aux joints de grains) et il a une meilleure stabilité mécanique, en particulier sous contrainte.

Comme le montre la figure 1E, des éléments de détection tels que des jauges piézorésistives 10 sont alors constituées à des endroits de la couche superficielle 4 déterminées en fonction de la forme de la future membrane. Ces jauges piézorésistives sont réalisées par une méthode connue de l'homme de l'art, par exemple par implantation ou diffusion ionique.

On dépose ensuite sur la couche superficielle 4 une couche conductrice qui est ensuite gravée pour constituer des contacts électriques 11 avec les jauges piézorésistives 10.

Dans cet exemple, le substrat 5 est ensuite usiné à partir de sa face arrière jusqu'à atteindre la couche de membrane 6 afin de constituer, pour chaque structure, une membrane circulaire rattachée à une partie périphérique. Une découpe transversale du substrat final permet de séparer les structures (voir la figure 1F).

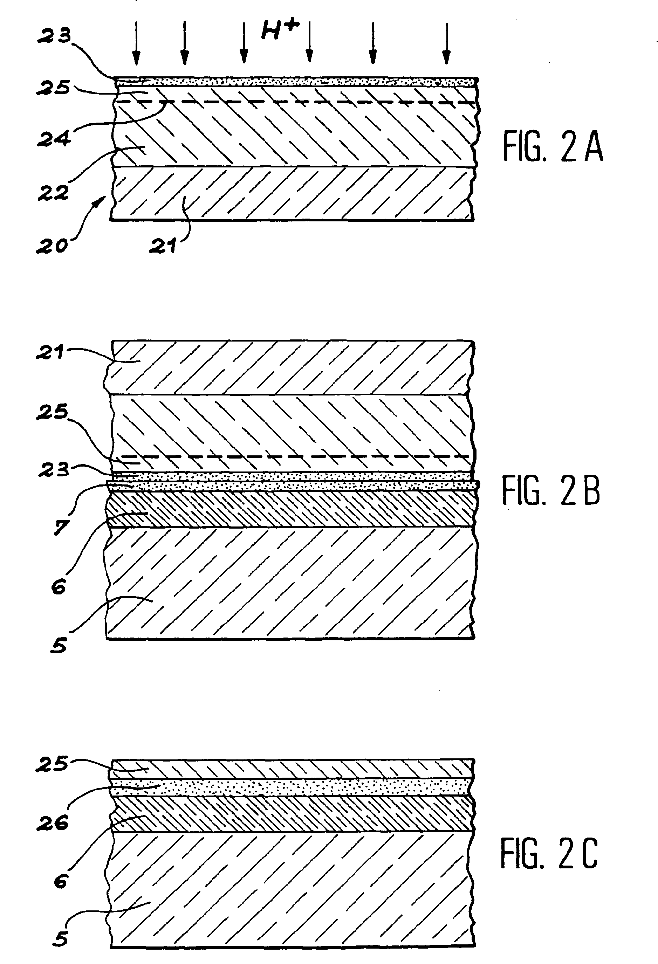

Les figures 2A à 2C sont des vues en coupe qui illustrent une deuxième variante de réalisation de structures micro-usinées selon l'invention. Pour la même raison que précédemment, on a représenté la réalisation d'une seule structure.

La différence entre cette variante et la précédente réside dans la constitution de la plaquette qui va fournir la couche superficielle de matériau semiconducteur.

Comme le montre la figure 2A, la plaquette 20 comprend un substrat support 21 sur lequel est fixé un bloc 22 de matériau correspondant à la couche superficielle. Le substrat support 21 est par exemple en silicium et le bloc 22 en carbure de silicium monocristallin. Ceci présente l'avantage de n'avoir pas à utiliser de substrat massif en carbure de silicium.

Une couche 23 d'oxyde de silicium d'une épaisseur de l'ordre de 500 nm a été déposée sur la plaquette 20.

Comme précédemment, une couche de microcavités 24 créée par implantation ionique définit l'épaisseur de la couche superficielle 25 que l'on veut reporter.

La couche de membrane est formée de la même façon que pour la première variante de réalisation, comme représenté à la figure 1B.

La figure 2B montre l'assemblage résultant du collage de la plaquette 20 sur le substrat 5.

Par un traitement thermique approprié, on provoque la coalescence des microcavités et le clivage de la plaquette le long de la couche de microcavités. On obtient alors, comme le montre la figure 2C, une couche superficielle 25 adhérant au substrat 5 et séparée du reste de la plaquette qui est réutilisable. Sur la figure 2C, les couches d'oxyde réunies par collage sont désignées sous la référence unique 26.

Les étapes suivantes de cette variante du procédé sont identiques à celles de la première variante décrite.

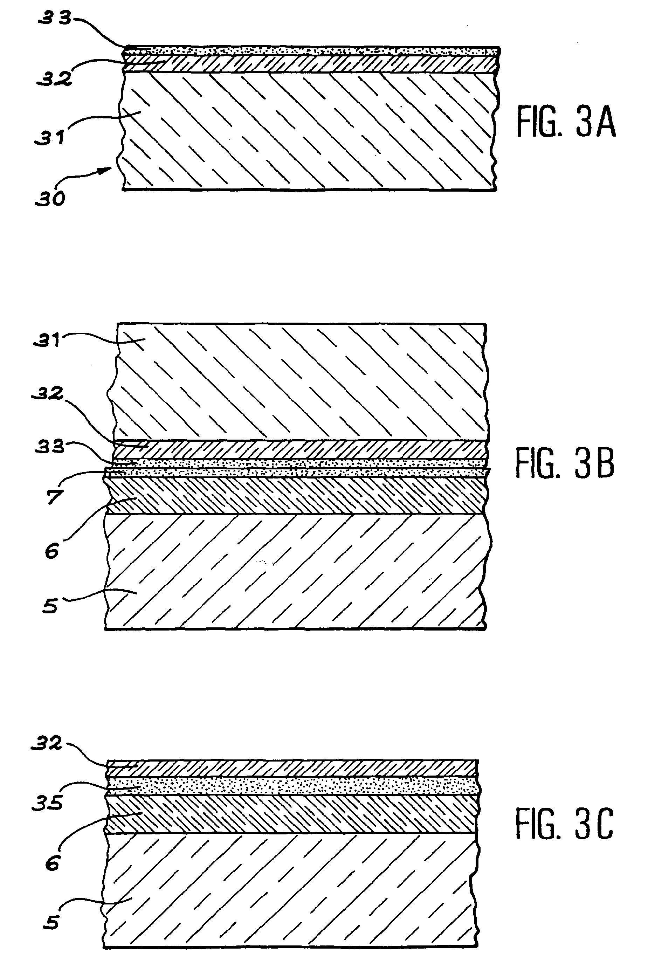

Les figures 3A à 3C sont des vues en coupe qui illustrent une troisième variante de réalisation de structures micro-usinées selon l'invention. Pour la même raison que précédemment, on a représenté la réalisation d'une seule structure.

La différence entre cette troisième variante et les précédentes réside aussi dans la constitution de la plaquette qui va fournir la couche superficielle de matériau semiconducteur monocristallin.

Comme le montre la figure 3A, la plaquette 30 comprend un substrat support 31 sur lequel est fixée directement la couche superficielle 32 à reporter. Le substrat support 31 est par exemple en silicium et la couche superficielle 32 en carbure de silicium monocristallin.

Une couche 33 d'oxyde de silicium d'une épaisseur de l'ordre de 500 nm a été formée sur la plaquette 30 par dépôt ou oxydation thermique.

La couche de membrane est formée de la même façon que pour la première variante de réalisation, comme représentée à la figure 1B.

La figure 3B montre l'assemblage résultant du collage de la plaquette 30 sur le substrat 5.

Le substrat support 31 est ensuite éliminé au moyen d'une gravure ou d'une dissolution chimique. On obtient alors, comme le montre la figure 3C, une couche superficielle 32 adhérant au substrat 5. Sur la figure 3C, les couches d'oxydes réunies par collage sont désignées sous la référence unique 35.

Les étapes suivantes de cette troisième variante du procédé sont identiques à celles de la première variante décrite.

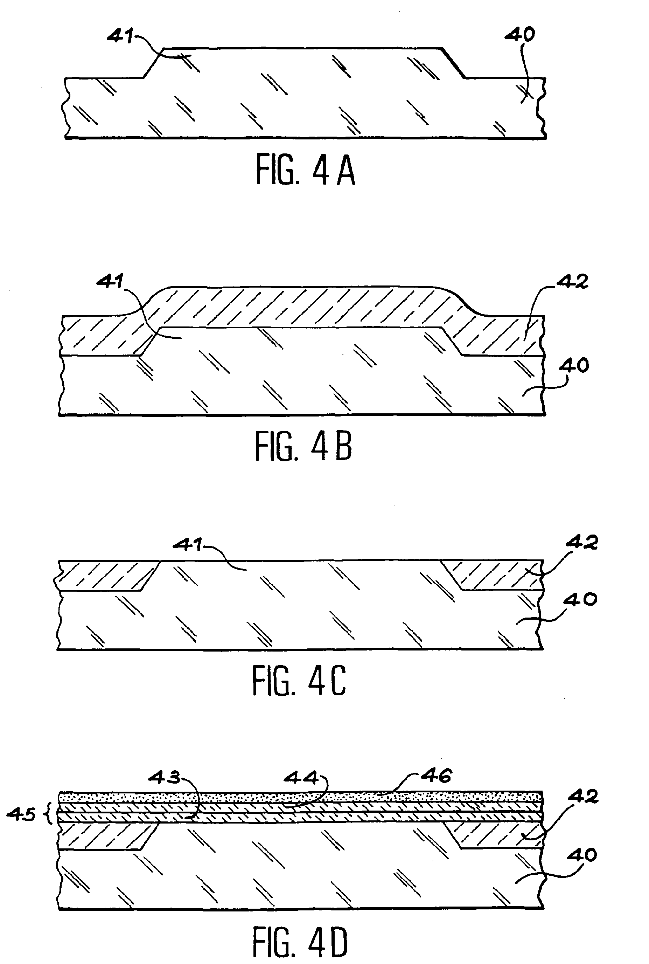

Les figures 4A à 4F sont des vues en coupe qui illustrent une quatrième variante de réalisation de structures micro-usinées selon l'invention. Pour la même raison que précédemment, on a représenté la réalisation d'un seul élément sensible.

La figure 4A montre un substrat 40 par exemple en silicium qui a été usiné, par exemple par gravure chimique, pour pourvoir sa face supérieure de bossages 41 de forme tronconique. A chaque bossage 41 correspond la réalisation d'un élément sensible. On peut employer en particulier la gravure utilisant des bases (par exemple KOH) permettant, à partir d'un substrat en silicium d'orientation (100), d'obtenir des cavités avec des bords orientés selon les plans (111) à 54°.

On dépose ensuite, sur la face supérieure du substrat 40 servant de matrice, une couche 42 de carbure de silicium polycristallin qui épouse la surface bosselée du substrat 40 (voir la figure 4B). La couche 42 peut être déposée grâce à une technique CVD.

Le substrat ainsi recouvert est ensuite arasé, par exemple par polissage mécano-chimique, pour obtenir la structure représentée à la figure 4C. Chaque sommet de bossage est découvert et chaque bossage 41 est entouré de carbure de silicium polycristallin 42.

Une première couche 43 de carbure de silicium monocristallin est ensuite reportée sur le substrat arasé. Une deuxième couche 44 de carbure de silicium monocristallin est épitaxiée sur la première couche 43. Les couches 43 et 44 constituent la couche 45 de carbure de silicium monocristallin (voir la figure 4D). La couche épitaxiée 44 permet de contrôler l'épaisseur de la membrane. Une couche 46 d'oxyde de silicium peut éventuellement être déposée sur la couche 45.

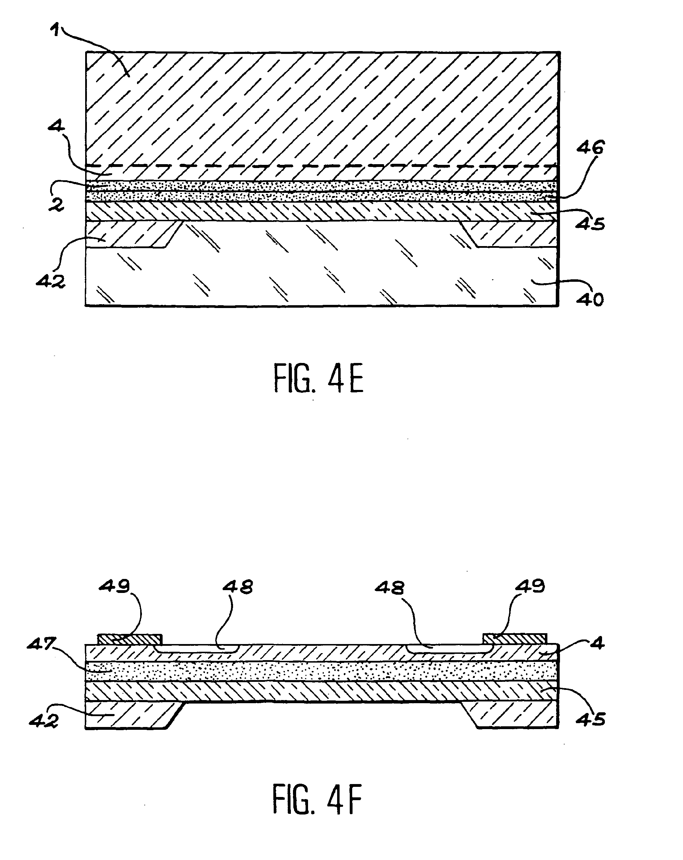

La structure représentée à la figure 4D est ensuite collée sur la plaquette 1, qui a été traitée de la manière illustrée par la figure 1A, par mise en contact intime de leurs couches d'oxyde 46 et 2 (voir la figure 4E) .

Par un traitement thermique approprié éventuellement assisté par l'application de forces mécaniques, on provoque la coalescence des microcavités et le clivage de la plaquette 1 le long de la couche de microcavités. La suite des opérations est analogue à celles décrites en liaison avec les figures 1D et 1E. Enfin, le substrat 40 est éliminé, par exemple par gravure chimique. On obtient alors la structure micro-usinée représentée à la figure 4F où les couches d'oxyde réunies par collage sont désignées sous la référence unique 47. Cette figure montre aussi les éléments de détection 48, par exemple des jauges piézorésistives, formées dans la couche superficielle 4 en carbure de silicium, et leurs contacts électriques 49.

## Revendications

1. Structure micro-usinée comportant une membrane déformable solidaire d'un support permettant sa déformation, la membrane comprenant au moins une couche de membrane (6) en matériau semiconducteur, ladite couche de membrane supportant des éléments (10) de détection de la déformation de la membrane réalisés en matériau semiconducteur, la membrane présentant une interface électriquement isolante avec les éléments de détection constituée par une couche électriquement isolante (8) et comportant en outre une couche superficielle (4) en carbure de silicium monocristallin dans laquelle sont réalisés lesdits éléments de détection (10), ladite couche superficielle étant une couche reportée sur la couche électriquement isolante,
**caractérisée en ce que** la couche de membrane (6) est en carbure de silicium, les éléments de détection (10) sont en carbure de silicium monocristallin et le support (5) est en silicium.

2. Structure micro-usinée selon la revendication 1, **caractérisée en ce que** la couche électriquement isolante (8) est constituée par une couche d'oxyde de silicium.

3. Procédé de fabrication par micro-usinage d'au moins une structure à membrane déformable solidaire d'un support
**caractérisé en ce qu'**il comporte les étapes suivantes :
- la formation, sur une face d'un substrat initial (5) en silicium, d'une couche de membrane (6) en carbure de silicium,
- le report, sur la couche de membrane (6) formée sur ledit substrat (5), d'une couche superficielle (4,25, 32) en carbure de silicium monocristallin, avec interposition d'une couche électriquement isolante (8, 26, 35, 47),
- la réalisation sur la face libre de la couche superficielle (4, 25, 32) d'éléments de détection (10) destinés à servir de moyens de détection de la déformation de la membrane (6),
- la réalisation de contacts électriques (11) sur ladite face libre destinés à connecter les éléments de détection (10) à des moyens de liaison électrique,
- la libération de la membrane de ladite structure.

4. Procédé selon la revendication 3, **caractérisé en ce que** la libération de la membrane de ladite structure est obtenue par élimination de matière à partir de l'autre face du substrat (5).

5. Procédé selon la revendication 3, **caractérisé en ce que** la libération de la membrane de ladite structure est obtenue par élimination d'une matrice (40) de forme complémentaire à la structures micro-usinée.

6. Procédé selon l'une quelconque des revendications 3 à 5, **caractérisé en ce que**, le procédé étant un procédé de fabrication collective de structures micro-usinées, il comporte une étape finale de découpe pour obtenir des structures séparées.

7. Procédé selon la revendication 3, **caractérisé en ce que** la formation de la couche de membrane (6) sur le substrat initial (5) se fait par dépôt.

8. Procédé selon l'une quelconque des revendications 3 à 7, **caractérisé en ce que** le report de ladite couche superficielle (4) en carbure de silicium monocristallin est obtenu a partir d'une plaquette (1) du même matériau dans laquelle cette couche superficielle (4) a été définie par une couche de microcavités (3) générées par implantation ionique, ladite plaquette (1) étant collée sur la couche de membrane (6) formée sur le substrat initial (5), puis clivée au niveau de la couche de microcavités (3) pour ne conserver que la couche superficielle (4) sur la couche de membrane (6).

9. Procédé selon l'une quelconque des revendications 4 à 6, **caractérisé en ce que** le report de ladite couche superficielle (25) en carbure de silicium monocristallin est obtenu à partir d'une plaquette (20) comprenant une couche (22) du même matériau solidaire d'un substrat support (21), la couche superficielle (25) étant définie dans ladite couche (20) du même matériau par une couche de microcavités (24) générées par implantation ionique, ladite plaquette (20) étant collée sur la couche de membrane (6) formée sur le substrat initial (5), puis clivée au niveau de la couche de microcavités (24) pour ne conserver que la couche superficielle (25) sur la couche de membrane (6) .

10. Procédé selon l'une des revendications 8 ou 9, **caractérisé en ce que** le clivage de la plaquette (1, 20) est obtenu par la coalescence des microcavités résultant d'un traitement thermique.

11. Procédé selon l'une quelconque des revendications 8 à 10, **caractérisé en ce que** l'épaisseur de ladite couche superficielle (4, 25) reportée est complétée et contrôlée par épitaxie du même matériau constituant cette couche superficielle.

12. Procédé selon l'une quelconque des revendications 3 à 7, **caractérisé en ce que** le report de ladite couche superficielle (32) en carbure de silicium monocristallin est obtenu à partir d'une plaquette (30) comprenant ladite couche superficielle (32) solidaire d'un substrat support (31), ladite plaquette (30) étant collée sur la couche de membrane (6) formée sur le substrat initial (5), le substrat support (31) de la plaquette (30) étant ensuite éliminé pour ne conserver que la couche superficielle (32) sur la couche de membrane (6).

13. Procédé selon la revendication 12, **caractérisé en ce que** ladite élimination du substrat support (31) est réalisée par une méthode choisie parmi la gravure et la dissolution chimique.

14. Procédé selon l'une quelconque des revendications 8 à 13, **caractérisé en ce que** le collage de la plaquette (30) sur la couche de membrane (6) est obtenu par adhésion moléculaire.

15. Procédé selon la revendication 14, **caractérisé en ce que** la couche électriquement isolante (35) interposée entre la couche superficielle (32) et la couche de membrane (6) est composée d'une première couche (33) électriquement isolante formée sur la couche superficielle (32) et d'une deuxième couche (7) électriquement isolante formée sur la couche de membranes (6), lesdites première et deuxième couches électriquement isolantes étant choisies pour contribuer au collage par adhésion moléculaire.

16. Procédé selon l'une quelconque des revendications 3 à 15, **caractérisé en ce que** les éléments de détection étant des jauges piézorésistives (10), celles-ci sont réalisées par une méthode choisie parmi l'implantation ionique et la diffusion ionique.

17. Procédé selon l'une quelconque des revendications 3 à 16, **caractérisé en ce que** lesdits contacts électriques (11) sont réalisés par dépôt d'une couche métallique sur la face libre de la couche superficielle (4) et par gravure de cette couche métallique.

18. Procédé selon l'une des revendications 4 ou 5, **caractérisé en ce que** ladite élimination de matière est obtenue par une méthode choisie parmi l'usinage mécanique et la gravure chimique.

## Claims

1. A micromachined structure including a deformable membrane secured on a support allowing its deformation, wherein the membrane comprises at least a membrane layer (6) in semiconducting material, said membrane layer supporting components (10) for detecting the deformation of the membrane, made in semiconducting material, the membrane having an electrically insulating interface with the detection components consisting of an electrically insulating layer (8) and further including a surface layer (4) of single crystal silicon carbide in which are made said detection components (10), wherein said surface layer is a layer transferred on the electrically insulating layer, **characterized in that** the membrane layer (6) is in silicon carbide, the detection components (10) are in single crystal silicon carbide and the support (5) is in silicon.

2. The micromachined structure according to claim 1, **characterized in that** the electrically insulating layer (8) consists of a silicon oxide layer.

3. A method for making by means of micro-machining at least a structure with a deformable membrane secured on a support, **characterized in that** it includes the following steps:
- forming, on a face of an initial substrate (5) in silicon, a membrane layer (6) in silicon carbide,
- transferring, on the membrane layer (6) formed on said substrate (5), a surface layer (4, 25, 32) in single crystal silicon carbide, with interposition of an electrically insulating layer (8, 26, 35, 47),
- making, on the free face of the surface layer (4, 25, 32), detection components (10) to be used as means for detecting the deformation of the membrane (6),
- making electrical contacts (11) on said free face for connecting the detection components (10) to electrical connection means,
- releasing the membrane from said structure.

4. The method according to claim 3, **characterized in that** the release of the membrane from said structure is obtained by removal of material from the other side of the substrate (5).

5. The method according to claim 3, **characterized in that** the release of the membrane of said structure is obtained by removal of a matrix (40) of a complementary shape to the micromachined structure.

6. The method according to any of claims 3 to 5, **characterized in that** the method is a collective manufacturing method for micromachined structures, and includes a final cutting step in order to obtain separate structures.

7. The method according to claim 3, **characterized in that** the formation of the membrane layer (6) on the initial substrate (5) is accomplished by deposition.

8. The method according to any of claims 3 to 7, **characterized in that** the transfer of said surface layer (4) in single crystal silicon carbide is obtained from a wafer (1) of the same material in which this surface layer (4) was defined by a layer of microcavities (3) generated by ion implantation, wherein said wafer (1) is stuck on the membrane layer (6) formed on the initial substrate (5), then cleaved at the microcavity layer (3) in order to only retain the surface layer (4) on the membrane layer (6).

9. The method according to any of claims 4 to 6, **characterized in that** the transfer of said surface layer (25) in single crystal silicon carbide is obtained from a wafer (20) comprising a layer (22) of the same material secured on a support substrate (21), wherein the surface layer (25) is defined in said layer (20) of the same material by a layer of microcavities (24) generated by ion implantation, wherein said wafer (20) is stuck on the membrane layer (6) formed on the initial substrate (5), then cleaved at the microcavity layer (24) in order to only retain the surface layer (25) on the membrane layer (6).

10. The method according to any of claims 8 or 9, **characterized in that** the cleavage of wafer (1, 20) is obtained by coalescence of microcavities resulting from a heat treatment.

11. The method according to any of claims 8 to 10, **characterized in that** the thickness of said transferred surface layer (4, 25) is completed and monitored by epitaxy of the same material making up this surface layer.

12. The method according to any of claims 3 to 7, **characterized in that** the transfer of said surface layer (32) in single crystal silicon carbide is obtained from a wafer (30) comprising said surface layer (32) secured on a support substrate (31) wherein said wafer (30) is stuck on the membrane layer (6) formed on the initial substrate (5) wherein the support substrate (31) of wafer (30) is then removed in order to only retain the surface layer (32) on the membrane layer (6).

13. The method according to claim 12, **characterized in that** said removal of the support substrate (31) is achieved by a method selected from chemical dissolution and etching.

14. The method according to any of claims 8 to 13, **characterized in that** the sticking of the wafer (30) on the membrane layer (6) is obtained by molecular adhesion.

15. The method according to claim 14, **characterized in that** the electrically insulating layer (35) interposed between the surface layer (32) and the membrane layer (6) consists of a first electrically insulating layer (33) formed on the surface layer (32) and of a second electrically insulating layer (7) formed on the membrane layer (6), wherein said first and second electrically insulating layers are selected in order to contribute to the sticking by molecular adhesion.

16. The method according to any of claims 3 to 15, **characterized in that** the detection components are piezoresistive gauges (10) and are made by means of a method selected from ion implantation and ion diffusion.

17. The method according to any of claims 3 to 16, **characterized in that** said electrical contacts (11) are made by depositing a metal layer on the free surface of the surface layer (4) and by etching this metal layer.

18. The method according to any of claims 4 or 5, **characterized in that** said removal of material is obtained by a method selected from mechanical machining and chemical etching.

## Patentansprüche

1. Mikrobearbeitete Struktur, umfassend eine verformbare Membran, die mit einem Träger fest verbunden ist, der ihre Verformung zulässt, wobei die Membran zumindest eine Membranschicht (6) aus einem Halbleitermaterial umfasst, wobei die Membranschicht Elemente (10) zur Detektion der Verformung der Membran trägt, die aus einem Halbleitermaterial hergestellt sind, wobei die Membran eine elektrisch isolierende Grenzfläche mit den Detektionselementen aufweist, die durch eine elektrisch isolierende Schicht (8) gebildet ist, und ferner eine Oberflächenschicht (4) aus monokristallinem Siliciumcarbid umfasst, in der die Detektionselemente (10) ausgebildet sind, wobei die Oberflächenschicht eine auf die elektrisch isolierende Schicht übertragene Schicht ist,
**dadurch gekennzeichnet, dass** die Membranschicht (6) aus Siliciumcarbid ist, die Detektionselemente (10) aus monokristallinem Siliciumcarbid sind und der Träger (5) aus Silicium ist.

2. Mikrobearbeitete Struktur nach Anspruch 1, **dadurch gekennzeichnet, dass** die elektrisch isolierende Schicht (8) durch eine Siliciumoxidschicht gebildet ist.

3. Verfahren zur Herstellung durch Mikrobearbeitung von zumindest einer Struktur mit verformbarer Membran, die mit einem Träger fest verbunden ist, **dadurch gekennzeichnet, dass** es die folgenden Schritte umfasst:
- das Ausbilden einer Membranschicht (6) aus Siliciumcarbid auf einer Oberfläche eines Ausgangssubstrats (5) aus Silicium,
- das Übertragen einer Oberflächenschicht (4, 25, 32) aus monokristallinem Siliciumcarbid auf die auf dem Substrat (5) ausgebildete Membrandschicht (6), wobei dazwischen eine elektrisch isolierende Schicht (8, 26, 35, 47) angeordnet wird,
- das Bereitstellen von Detektionselementen (10) an der freien Oberfläche der Oberflächenschicht (4, 25, 32), die dazu vorgesehen sind, als Mittel zur Detektion der Verformung der Membran (6) zu dienen,
- das Bereitstellen von elektrischen Kontakten (11) an der freien Oberfläche, die dazu vorgesehen sind, die Deiektionselemente (10) mit elektrischen Verbindungsmitteln zu verbinden,
- das Lösen der Membran von der Struktur.

4. Verfahren nach Anspruch 3, **dadurch gekennzeichnet, dass** das Lösen der Membran von der Struktur durch das Beseitigen von Material ausgehend von der anderen Oberfläche des Substrats (5) erzielt wird.

5. Verfahren nach Anspruch 3, **dadurch gekennzeichnet, dass** das Lösen der Membran von der Struktur durch das Beseitigen einer Matrize (40) von komplementärer Form zur mikrobearbeiteten Struktur erzielt wird.

6. Verfahren nach einem der Ansprüche 3 bis 5, **dadurch gekennzeichnet, dass** das Verfahren, welches ein Verfahren der Sammelherstellung ist, einen abschließenden Schritt des Schneidens umfasst, um separate Strukturen zu erhalten.

7. Verfahren nach Anspruch 3, **dadurch gekennzeichnet, dass** das Ausbilden der Membranschicht (6) auf dem Ausgangssubstrat (5) durch Abscheiden erfolgt.

8. Verfahren nach einem der Ansprüche 3 bis 7, **dadurch gekennzeichnet, dass** das Übertragen der Oberflächenschicht (4) aus monokristallinem Siliciumcarbid ausgehend von einer Scheibe (1) aus dem gleichen Material erzielt wird, in der die Oberflächenschicht (4) durch eine Schicht von Mikrokavitäten (3), erzeugt durch lonenimplantation, definiert wurde, wobei die Scheibe (1) auf der auf dem Ausgangssubstrat (5) ausgebildeten Membranschicht (6) aufgeklebt und anschließend auf der Ebene der Schicht von Mikrokavitäten (3) gespalten wird, um nur die Oberflächenschicht (4) auf der Membranschicht (6) zu bewahren.

9. Verfahren nach einem der Ansprüche 4 bis 6, **dadurch gekennzeichnet, dass** das Übertragen der Oberflächenschicht (25) aus monokristallinem Siliciumcarbid ausgehend von einer Scheibe (20) erzielt wird, die eine Schicht (22) aus dem gleichen Material, die fest mit einem Trägersubstrat (21) verbunden ist, umfasst, wobei die Oberflächenschicht (25) in der Schicht (20) aus dem gleichen Material durch eine Schicht von Mikrokavitäten (24), erzeugt durch lonenimplantation, definiert ist, wobei die Scheibe (20) auf der auf dem Ausgangssubstrat (5) ausgebildeten Membranschicht (6) aufgeklebt und anschließend auf der Ebene der Schicht von Mikrokavitäten (24) gespalten wird, um nur die Oberflächenschicht (25) auf der Membranschicht (6) zu bewahren.

10. Verfahren nach einem der Ansprüche 8 oder 9, **dadurch gekennzeichnet, dass** das Spalten der Scheibe (1, 20) durch das Zusammenwachsen der Mikrokavitäten infolge einer Wärmebehandlung erzielt wird.

11. Verfahren nach einem der Ansprüche 8 bis 10, **dadurch gekennzeichnet, dass** die Dicke der übertragenen Oberflächenschicht (4, 25) durch Epitaxie des gleichen Materials, das die Oberflächenschicht bildet, vervollständigt und kontrolliert wird.

12. Verfahren nach einem der Ansprüche 3 bis 7, **dadurch gekennzeichnet, dass** das Übertragen der Oberflächenschicht (32) aus monokristallinem Siliciumcarbid ausgehend von einer Scheibe (30) erzielt wird, die die Oberflächenschicht (32) fest mit einem Trägersubstrat (31) verbunden umfaßt, wobei die Scheibe (30) auf der auf dem Ausgangssubstrat (5) ausgebildeten Membranschicht (6) aufgeklebt und anschließend das Trägersubstrat (31) der Scheibe (30) beseitigt wird, um nur die Oberfifächenschicht (32) auf der Membranschicht (6) zu bewahren.

13. Verfahren nach Anspruch 12, **dadurch gekennzeichnet, dass** das Beseitigen des Trägersubstrats (31) durch ein aus Ätzung und chemischer Auflösung ausgewähltes Verfahren erzielt wird.

14. Verfahren nach einem der Ansprüche 8 bis 13, **dadurch gekennzeichnet, dass** das Aufkleben der Scheibe (30) auf der Membranschicht (6) durch Moleküladhäsion erzielt wird.

15. Verfahren nach Anspruch 14, **dadurch** gekenntzeichnet, dass die elektrisch isolierende Schicht (35), die zwischen der Oberflächenschicht (32) und der Membranschicht (6) angeordnet ist, aus einer ersten elektrisch isolierenden Schicht (33), die an der Oberflächenschicht (32) ausgebildet ist, und einer zweiten elektrisch isolierenden Schicht (7), die an der Membranschicht (6) ausgebildet ist, gebildet ist, wobei die erste und die zweite elektrisch isolierende Schicht ausgewählt sind, um zum Aufkleben durch Moleküladhäsion beizutragen.

16. Verfahren nach einem der Ansprüche 3 bis 15, **dadurch gekennzeichnet, dass** die Detektionselemente piezoresistive Messstreifen (10) sind, die durch ein aus lonenimplantation und Ionendiffusion ausgewähltes Verfahren bereitgestellt werden.

17. Verfahren nach einem der Ansprüche 3 bis 16, **dadurch gekennzeichnet, dass** die elektrischen Kontakte (11) durch Abscheiden einer Metallschicht auf der freien Oberfläche der Oberflächenschicht (4) und Ätzen der Metallschicht bereitgestellt werden.

18. Verfahren nach einem der Ansprüche 4 oder 5, **dadurch gekennzeichnet, dass** das Beseitigen von Material durch ein aus mechanischer Bearbeitung und chemischer Ätzung ausgewähltes Verfahren erzielt wird.
